# EUROPEAN PATENT SPECIFICATION

(11) **EP 2 750 490 B1**
(45) Date of publication and mention of the grant of the patent: **16.11.2016**
(21) Application number: 12825526.2
(22) Date of filing: 21.08.2012
(51) Int. Cl.: H05K 3/12, H05K 1/11, H05K 3/40, H05K 3/30, H01L 23/14, H01L 23/498, H01L 21/48, H05K 3/00

(54) **COMPONENT-MOUNTING PRINTED CIRCUIT BOARD AND MANUFACTURING METHOD FOR SAME**
BESTÜCKUNGSLEITERPLATTE UND HERSTELLUNGSVERFAHREN DAFÜR
CARTE DE CIRCUIT IMPRIMÉ DE MONTAGE DE COMPOSANT ET SON PROCÉDÉ DE FABRICATION

(30) Priority: 23.08.2011 JP 2011181271
(43) Date of publication of application: 02.07.2014
(73) Proprietor: Fujikura Ltd., Tokyo 135-8512 (JP)
(72) Inventor: HONDO, Takaharu, Sakura-shi Chiba 285-8550 (JP)
(74) Representative: Grünecker Patent- und Rechtsanwälte PartG mbB
(86) International application number: PCT/JP2012/071052
(87) International publication number: WO 2013/027718

(56) References cited:
- EP-A1- 2 200 412
- JP-A- H0 362 542
- JP-A- 2000 208 675
- JP-A- 2003 008 178
- JP-A- 2003 318 234
- JP-A- 2006 049 804
- US-A1- 2005 045 379
- US-A1- 2008 202 801
- US-A1- 2011 001 222

## Description

### Technical Field

This invention relates to a component-mounting printed board having an electronic component surface-mounted thereon, and a method of manufacturing the component-mounting printed board.

### Background Art

Known as a conventional component-mounting printed board having an electronic component mounted on a surface thereof is the component-mounting printed board disclosed in Patent Document 1 identified below. In this semiconductor component, a solder bump formed on an electrode of an electronic component is joined to an electrode pad formed on a component-mounting surface of a wiring board, thereby securing electrical conduction of the two. Moreover, a solder bump is formed also on an electrode pad formed on a surface on an opposite side to the component-mounting surface of the wiring board, whereby connection is made to a mounting board such as a mother board, or the like. The electrode pads of each of the surfaces are connected via an interlayer-connecting conductor and an inner layer wiring.

### Prior Art Document

### Patent Document

Patent Document 1: Unexamined Japanese Patent Application Publication No. JP 2011-44512 A

Further relevant background art is disclosed in documents EP 2 200 412, US 2005/0045379 and JP 2003 008178.

### Summary of the Invention

### Problem to be solved by the Invention

However, in mounting technology such as a BGA system where an electronic component and a wiring board are connected via the likes of a solder bump as in the above-described component-mounting printed board disclosed in Patent Document 1, a diameter of the solder bump attains a size of about 100 µm, hence there is a problem that thinning of the wiring board overall is difficult to achieve. In addition, a formation pitch of the solder bump is also limited due to the size of the solder bump itself, hence there is also a problem that narrowing of pitch of the electrode pad is difficult to achieve, and mounting by high density wiring is difficult.

This invention has an object of solving the above-mentioned problems due to conventional technology to provide a component-mounting printed board capable of being thinned and capable of high density mounting, and a method of manufacturing the component-mounting printed board.

### Means for solving the Problem

A component-mounting printed board according to the present invention is defined in claim 1.

As a result of the component-mounting printed board according to the present invention, an electrode of an electronic component mounted on a mounting surface of a resin base and a through-hole electrode formed in the resin base are directly joined, thereby enabling greater thinning and enabling higher density mounting compared to a component-mounting printed board where these are joined via a solder bump. In addition, an electrode pad of the through-hole electrode is embedded in the resin base and formed in a surface on an opposite side to a side of a mounting surface on which the electronic component is mounted of the resin base, thereby enabling greater thinning compared to a component-mounting printed board where the electrode pad is formed on the surface of the resin base.

Note that in an embodiment of the present invention, the electrode of the electronic component is embedded in the resin base. Doing so enables further thinning.

Moreover, another embodiment of the present invention further comprises a circuit formed on the side of the mounting surface on which the electronic component is mounted of the resin base.

Moreover, in yet another embodiment of the present invention, an adhesive layer is formed between an electrode formation surface of the electronic component and the mounting surface of the resin base.

Moreover, in yet another embodiment of the present invention, the adhesive layer is formed only in an underside region of the electronic component.

A method of manufacturing a component-mounting printed board according to the present invention comprises: forming a circuit pattern in a resin base by imprinting, the circuit pattern including a through-hole; aligning an electrode of an electronic component with the through-hole of the circuit pattern to perform alignment, and then mounting the electronic component on the resin base; and filling a conductive paste into the circuit pattern to form in the resin base wiring including a through-hole electrode corresponding to the through-hole and directly join the electrode of the electronic component and the through-hole electrode, and forming an electrode pad of the through-hole electrode being embedded in the resin base in a surface on an opposite side to a side of a mounting surface on which the electronic component is mounted of the resin base.

As a result of the method of manufacturing a component-mounting printed board according to the present invention, a circuit pattern is formed in a resin base by imprinting, an electronic component undergoes alignment and is then mounted on the resin base, and a conductive paste is filled into the circuit pattern to form wiring, hence an electrode of the electronic component and a through-hole electrode can be directly joined and an electrode pad of the through-hole electrode can be embedded in the resin base and formed in a surface on an opposite side to a side of a mounting surface on which the electronic component is mounted of the resin base. As mentioned above, this enables thinning and enables high density mounting.

In an embodiment of the present invention, when mounting the electronic component on the resin base, the electronic component is mounted while the resin base is heated and while a contact surface with the electrode of the electronic component of the resin base is pressurized.

Moreover, in another embodiment of the present invention, an intermetallic compound is formed between the electrode of the electronic component and the conductive paste.

Moreover, in yet another embodiment of the present invention, prior to mounting the electronic component on the resin base, an adhesive layer is formed in a region where the electrode in an electrode formation surface of the electronic component is not formed.

In yet another embodiment of the present invention, the adhesive layer is formed such that a surface thereof is in a state of being more sunken to a side of the electrode formation surface of the electronic component than is an electrode surface of the electrode of the electronic component.

### Effects of the Invention

The present invention enables thinning and enables high density mounting.

### Brief Description of Drawings

Fig. 1 is a cross-sectional view showing a structure of a component-mounting printed board according to a first embodiment of the present invention.
Fig. 2 is a flowchart showing a manufacturing process of same component-mounting printed board.
Fig. 3 is a cross-sectional view showing same component-mounting printed board in a first manufacturing process sequence.
Fig. 4 is a cross-sectional view showing same component-mounting printed board in a second manufacturing process sequence.
Fig. 5 is a cross-sectional view showing another structure of same component-mounting printed board.
Fig. 6 is a cross-sectional view showing yet another structure of same component-mounting printed board.
Fig. 7 is a cross-sectional view showing a structure of a component-mounting printed board according to a second embodiment of the present invention.
Fig. 8 is a flowchart showing part of a manufacturing process of same component-mounting printed board.
Fig. 9 is a cross-sectional view showing an electronic component of same component-mounting printed board in a partial manufacturing process sequence.
Fig. 10 is a cross-sectional view showing same component-mounting printed board in a first manufacturing process sequence.
Fig. 11 is a cross-sectional view showing same component-mounting printed board in a second manufacturing process sequence.
Fig. 12 is a cross-sectional view showing an electronic component of same component-mounting printed board in a manufacturing process sequence.
Fig. 13 is a cross-sectional view showing same component-mounting printed board in a manufacturing process sequence.

### Embodiments for carrying out the Invention

A component-mounting printed board and a method of manufacturing the same according to embodiments of this invention will be described in detail below with reference to the accompanying drawings.

### [First Embodiment]

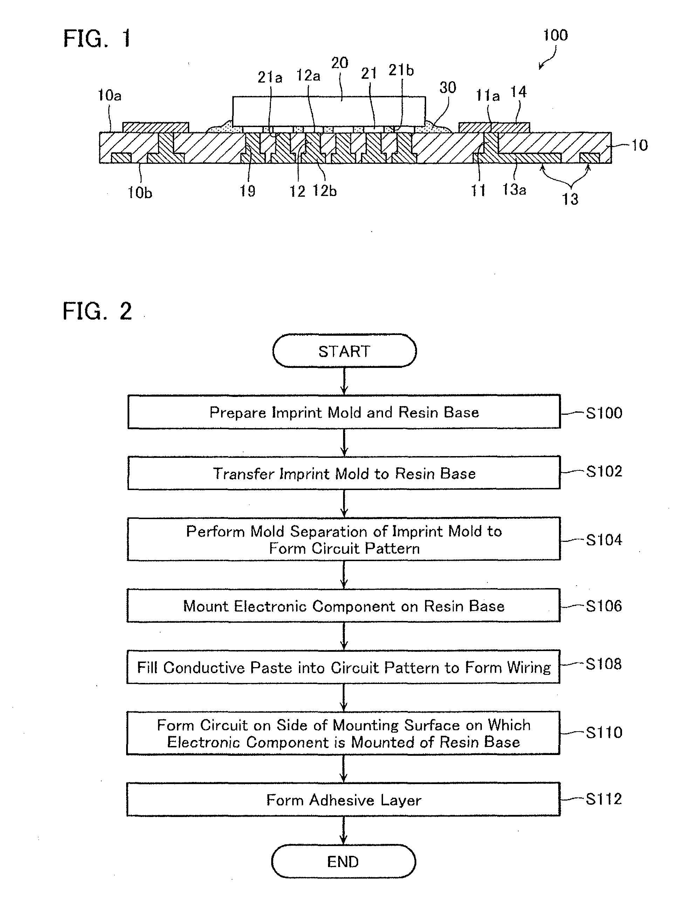

Fig. 1 is a cross-sectional view showing a structure of a component-mounting printed board according to a first embodiment of the present invention. A component-mounting printed board 100 according to the first embodiment comprises: a resin base 10; and an electronic component 20 mounted on at least one of surfaces, namely a mounting surface 10a, of this resin base 10. In addition, the component-mounting printed board 100 comprises: a through-hole electrode 12 in a through-hole 19 formed in the resin base 10; rear surface wiring 13; and a surface layer circuit 14.

The resin base 10 is configured by, for example, a resin film having a thickness of about 25 um. Employable as the resin film are, for example, a resin film configured from the likes of a thermoplastic polyimide, polyolefin, or liquid crystal polymer, or a resin film configured from a thermosetting epoxy resin, and so on.

The electronic component 20 is a semiconductor component such as an IC chip, and has formed on an electrode formation surface 21b thereof facing the mounting surface 10a of the resin base 10 a plurality of mounting-dedicated electrodes 21 each comprising an electrode surface 21a parallel to the electrode formation surface 21b. The through-hole electrode 12 and the rear surface wiring 13 are configured from a conductive paste filled into a concave circuit pattern that includes a through-hole 19 and is formed by impressing irregularities of an imprint mold into the resin base 10.

The conductive paste includes, for example, at least one kind of metallic particle of low electrical resistance selected from the likes of nickel, gold, silver, zinc, aluminum, iron, and tungsten, and at least one kind of metallic particle of low melting point selected from the likes of bismuth, indium, and lead. Moreover, the conductive paste has tin included as a component in these metallic particles, and is configured from a paste having mixed therein a binder component whose main component is an epoxy, an acrylic, a urethane, and so on.

The conductive paste configured in this way enables the tin and the metal of low melting point included therein to melt and form an alloy at a temperature of 200°C or less, and specifically, the likes of copper or silver comprise characteristics allowing an intermetallic compound to be formed. Note that the conductive paste may also be configured by a nanopaste in which, for example, a filler of the likes of gold, silver, copper, or nickel with a nanolevel particle diameter is mixed into a binder component of the above-described kind. In addition, the conductive paste may also be configured by a paste having metallic particles of the above-described nickel, and so on, mixed into a binder component of the above-described kind. In this case, the conductive paste is characterized in that electrical connection is performed by contact between fellow metallic particles.

The through-hole electrode 12 comprises: an electrode 12a formed on a side of the mounting surface l0a of the resin base 10; and an electrode pad 12b formed on a side of a rear surface 10b on an opposite side to the mounting surface 10a of the resin base 10. The rear surface wiring 13 includes: a wiring main portion 13a formed on the rear surface 10b side of the resin base 10 ; and an interlayer connector 11 that makes interlayer connection between this wiring main portion 13a and the surface layer circuit 14. Provided on a mounting surface 10a side of the interlayer connector 11 is an electrode 11a connected to the surface layer circuit 14.

The surface layer circuit 14 is configured from a conductive member of copper, or the like, pattern formed on the mounting surface 10a of the resin base 10 after mounting of the electronic component 20, by a system of photolithography, printing, ink jet, or the like. Note that the resin base 10 and the electronic component 20 are connected by an adhesive layer 30 formed between the mounting surface 10a and the electrode formation surface 21b. The adhesive layer 30 is formed by filling an underfill between these mounting surface 10a and electrode formation surface 21b, the underfill being configured from the likes of a composite resin whose main agent is an epoxy system resin.

Note that although omitted from the drawings, the component-mounting printed board 100 may have a solder resist formed therein for protecting the rear surface wiring 13, the adhesive layer 30, the mounting surface 10a or rear surface 10b sides of the resin base 10, and so on. In this case, the solder resist is formed by, for example, a system of photolithography, or the like.

As a result of the component-mounting printed board 100 according to the first embodiment being configured in this way, the electrode 21 of the electronic component 20 and the electrode 12a of the through-hole electrode 12 are directly joined without mediation of a solder bump, or the like. Therefore, thinning of the component-mounting printed board 100 overall can be achieved, and an arrangement pitch of the electrodes 21 and 12a can be narrowed, thereby enabling high density mounting.

In addition, the wiring main portion 13a of the rear surface wiring 13 and the electrode pad 12b of the through-hole electrode 12 are formed in a state of being embedded further inside the resin base 10 than the rear surface 10b of the resin base 10, hence enabling further thinning to be achieved.

Next, a method of manufacturing a component-mounting printed board according to the first embodiment will be described.

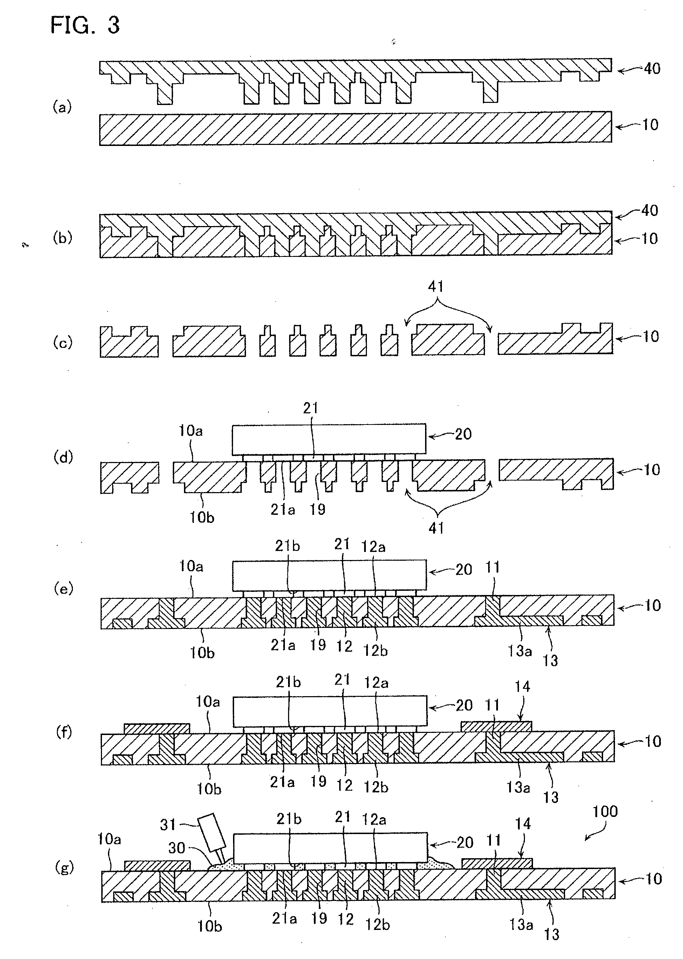

Fig. 2 is a flowchart showing a manufacturing process of the component-mounting printed board. Fig. 3 is a cross-sectional view showing the component-mounting printed board in a first manufacturing process sequence.

First, as shown in Fig. 3(a), for example, an imprint mold 40 which is a mold including a convex circuit shaped pattern or protrusion, and the resin base 10 configured from a thermoplastic polyimide resin film, are prepared (step S100).

The imprint mold 40 is configured from, for example, a mold manufactured from silicon and including the circuit shaped pattern with a minimum line/space of 5 µm/5 µm and a height of 5 µm. The imprint mold 40 may also be formed by the likes of nickel, copper, and diamond-like carbon (DLC), besides silicon, and may be applied with a mold separation-facilitating processing by having its front surface coated with a fluorine system resin.

Next, as shown in Fig. 3(b), the imprint mold 40 is impressed into the resin base 10 while being heated to a certain temperature, thereby transferring a circuit pattern configured by the circuit shaped pattern (step S102). At this time, the circuit pattern is preferably transferred after heating the resin base 10 and the imprint mold 40 to a temperature at which a resin material configuring the resin base 10 becomes soft.

Then, as shown in Fig. 3(c), cooling is performed to a temperature less than or equal to that at which the resin material becomes soft, and the imprint mold 40 undergoes mold separation from the resin base 10, whereby a concave circuit pattern 41 is formed in the resin base 10 (step S104). As shown in Fig. 3 (d), when the circuit pattern 41 has been formed, the resin base 10 is inverted, and the electrode 21 of the electronic component 20 undergoes alignment by being aligned with the through-hole 19 of the circuit pattern 41, after which the electronic component 20 is mounted on the mounting surface 10a of the resin base 10 (step S106).

In this step S106, the resin base 10 is configured from a thermoplastic polyimide resin film, hence, for example, the electronic component 20 is mounted after heating to a temperature greater than or equal to a glass-transition point, and cooling is performed after mounting. As a result, a portion of the electrode surface 21a of the electrode 21 is adhered to the mounting surface 10a of the resin base 10, whereby the electronic component 20 can be provisionally adhered to the resin base 10. Note that in the case that the resin base 10 is configured from a thermosetting resin film, a resin hardens due to heating, whereby the two are provisionally adhered.

As shown in Fig. 3(e), when the electronic component 20 has been mounted, the conductive paste is filled into the circuit pattern 41 from the rear surface 10b side of the resin base 10, by plating, ink jet, printing, or the like, thereby forming the through-hole electrode 12 and the rear surface wiring 13 (step S108). As a result, the electrode 21 of the electronic component 20 is directly joined to the through-hole electrode 12.

Note that in the above-described step S108, an excess portion of the conductive paste protruding from each of the surfaces 10a and 10b of the resin base 10 are removed by etching, or the like. As a result, the electrode pad 12b of the through-hole electrode 12 and the wiring main portion 13a of the rear surface wiring 13 can be formed in a state of being flat with the rear surface 10b of the resin base 10.

Then, as shown in Fig. 3(f), the surface layer circuit 14 connected to the rear surface wiring 13 is formed on the mounting surface 10a side of the resin base 10 by photolithography, printing, ink jet, or the like (step S110). Finally, as shown in Fig. 3(g), underfill is filled into a mounting portion of the electronic component 20 using the likes of a filling device 31 to form the adhesive layer 30 between the electrode formation surface 21b and the mounting surface 10a (step S112), whereby the electronic component 20 is truly adhered to the resin base 10 and the component-mounting printed board 100 is manufactured.

The component-mounting printed board 100 according to the first embodiment manufactured in this way allows thinning to be achieved and is capable of high density mounting as mentioned above. Note that the processings of the above-described steps S110 and S112 may be performed having an order thereof reversed. Moreover, the component-mounting printed board 100 may be manufactured as follows.

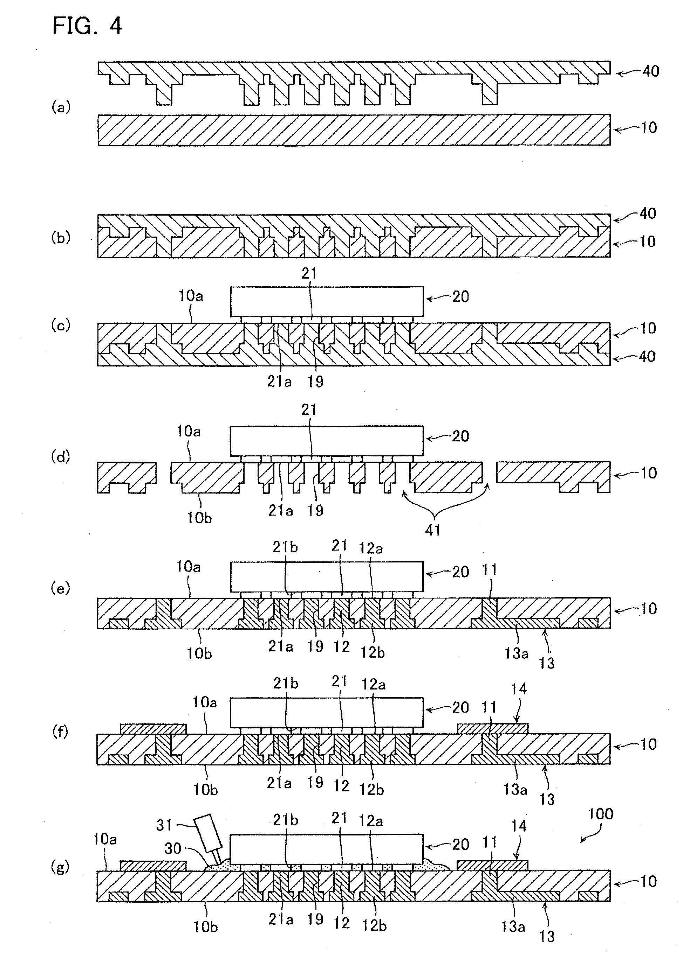

Fig. 4 is a cross-sectional view showing the component-mounting printed board in a second manufacturing process sequence. That is, this second manufacturing process is characterized in that an order of the step S104 and the step S106 in the above-described first manufacturing process is reversed. Specifically, first, as shown in Fig. 4 (a), the imprint mold 40 and the resin base 10 are prepared, and then, as shown in Fig. 4(b), the imprint mold 40 is impressed into the resin base 10 to transfer the circuit pattern.

Next, as shown in Fig. 4(c), the resin base 10 is inverted with the imprint mold 40 still attached thereto, alignment is performed by aligning the electrode 21 with the through-hole 19 to mount the electronic component 20 on the mounting surface 10a of the resin base 10, and a portion of the electrode surface 21a is adhered to the mounting surface 10a, thereby provisionally adhering the electronic component 20 to the resin base 10.

Then, as shown in Fig. 4(d), the imprint mold 40 undergoes mold separation from the resin base 10 to form the concave circuit pattern 41, and, as shown in Fig. 4(e), the conductive paste is filled into the circuit pattern 41 to form the through-hole electrode 12 and the rear surface wiring 13 and directly join the electrode 21 of the electronic component 20 to the through-hole electrode 12.

Next, as shown in Fig. 4(f), the surface layer circuit 14 is formed on the mounting surface 10a side of the resin base 10, and, as shown in Fig. 4(g), underfill is filled in to form the adhesive layer 30, whereby the electronic component 20 is truly adhered to the resin base 10. As a result of the second manufacturing process being configured to mount the electronic component 20 before performing mold separation of the imprint mold 40 from the resin base 10 in this way, loss of shape of the circuit pattern 41 formed in the resin base 10 during mounting can be more reliably prevented. In this second manufacturing process too, a processing for formation of the surface layer circuit 14 and a processing for formation of the adhesive layer 30 may be performed having an order thereof reversed.

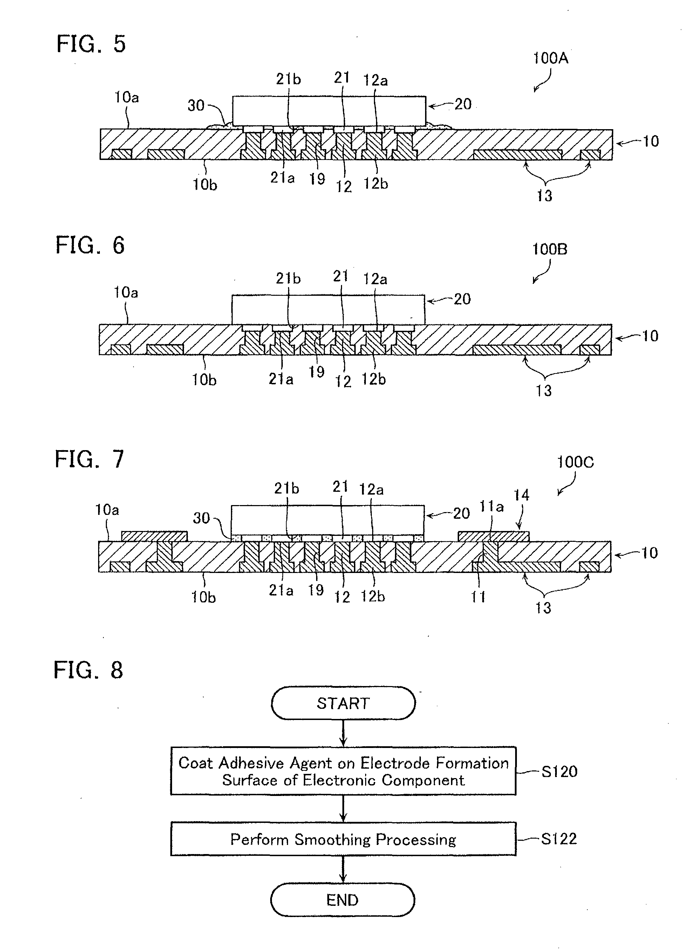

Note that the component-mounting printed board 100 may have the following structure. Fig. 5 is a cross-sectional view showing another structure of the component-mounting printed board, and Fig. 6 is a cross-sectional view showing yet another structure of the component-mounting printed board. As shown in Fig. 5, a component-mounting printed board 100A of the present example adopts a so-called single-sided wiring structure that has the rear surface wiring 13 and the electrode pad 12b of the through-hole electrode 12, and so on, formed on the rear surface 10b side of the resin base 10, but does not include the surface layer circuit 14 on the mounting surface 10a side of the resin base 10. By adopting the single-sided wiring structure, the interlayer connector 11 too is rendered unnecessary, hence a cost of materials and the number of processes can be reduced, whereby thinning and high density mounting are enabled while setting a low cost.

In addition, the component-mounting printed board 100A shown in Fig. 5 differs from that shown in Fig. 1 in having the electrode 21 of the electronic component 20 embedded in the resin base 10. In this case, a contact area of the electrode 21 of the electronic component 20 contacting the resin base 10 is large, hence the electronic component 20 can be more reliably provisionally adhered to the resin base 10. To embed the electrode 21 requires only that a temperature of heating or an applied pressure be appropriately changed during mounting of the electronic component 20 to the resin base 10.

Fig. 6 shows a component-mounting printed board 100B in which the electrode 21 of the electronic component 20 is completely embedded in a resin base 10 side. In this example, the resin base 10 and the electronic component 20 may be joined by a binding force between the electrode 21 and the resin base 10 and a binding force between the electrode 21 and the through-hole electrode 12 as illustrated, or a configuration may be adopted such that the adhesive layer 30 is formed only around the electronic component 20.

### [Second Embodiment]

Fig. 7 is a cross-sectional view showing a structure of a component-mounting printed board according to a second embodiment of the present invention. A component-mounting printed board 100C according to the second embodiment has a structure, formation process, and so on, of the adhesive layer 30 that differ from those of the component-mounting printed board 100 according to the first embodiment. That is, the adhesive layer 30 is formed only in an underside region of the electronic component 20, and underfill never protrudes outside of the electronic component 20 as in the adhesive layer 30 of the component-mounting printed board 100 according to the first embodiment.

As a result, the component-mounting printed board 100C according to the second embodiment has similar working effects to those of the component-mounting printed board 100 according to the first embodiment, and by eliminating a protruding portion of the adhesive layer 30 in the mounting surface 10a of the resin base 10, a mounting area of the electronic component 20 can be reduced, whereby consequently a mounting area on the mounting surface 10a side can be increased.

Next, a method of manufacturing a component-mounting printed board according to the second embodiment will be described.

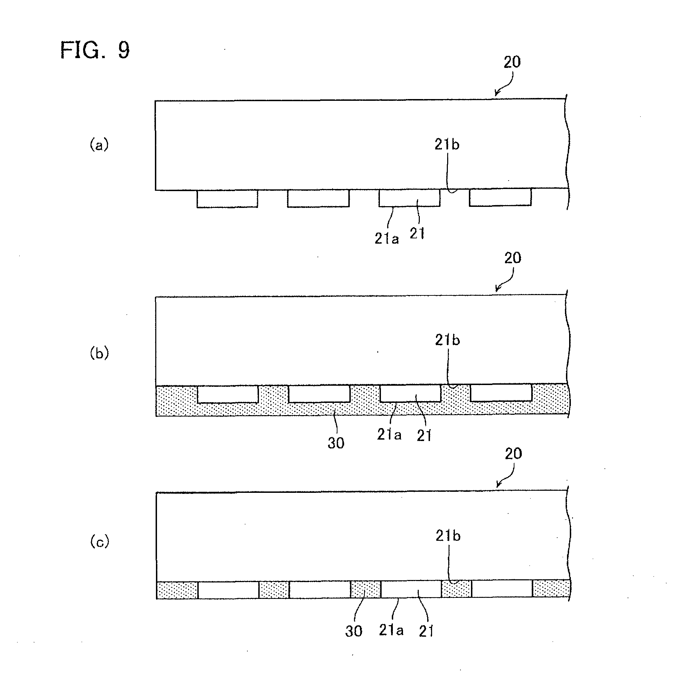

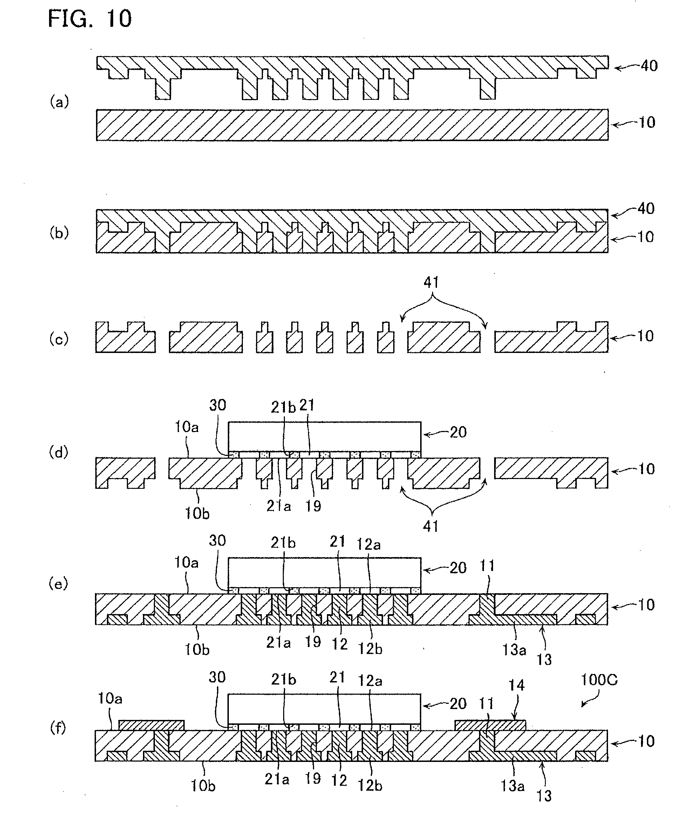

Fig. 8 is a flowchart showing part of a manufacturing process of the component-mounting printed board. Fig. 9 is a cross-sectional view showing the electronic component of the component-mounting printed board in a partial manufacturing process sequence, and Fig. 10 is a cross-sectional view showing the component-mounting printed board in a first manufacturing process sequence.

First, distinct from a main manufacturing process of the component-mounting printed board 100C shown in Fig. 10, as shown in Fig. 9(a), the electronic component 20 having a plurality of the electrodes 21 formed on the electrode formation surface 21b, is prepared, and, as shown in Fig. 9 (b), an adhesive agent is coated (or laminated) on this electrode formation surface 21b of the electronic component 20 (step S120).

The adhesive agent coated or laminated in this step S120 is preferably a liquid form or film form adhesive agent configured from the above-described kind of thermoplastic resin or semi-hardened-state thermosetting resin. Then, as shown in Fig. 9 (c), the electrode surface 21a of the electrode 21 is exposed and smoothing processing is performed by implementing etching or polishing, and so on, such that the adhesive agent does not protrude from a side surface of the electronic component 20 (step S122). In this way, the electronic component 20 having the adhesive layer 30 formed thereon, is prepared.

Then, as shown in Fig. 10(a), the imprint mold 40 and the resin base 10 are prepared, and, as shown in Fig. 10(b), the imprint mold 40 is impressed into the resin base 10 to transfer the circuit pattern. Subsequently, as shown in Fig. 10 (c), the imprint mold 40 undergoes mold separation from the resin base 10, whereby the concave circuit pattern 41 is formed in the resin base 10.

Next, as shown in Fig. 10(d), the resin base 10 is inverted and alignment of the electronic component 20 is performed, and then the electronic component 20 is mounted on the mounting surface 10a, a portion of the electrode surface 21a of the electrode 21 is adhered to the mounting surface 10a of the resin base 10, and the electronic component 20 is truly adhered to the resin base 10 by the adhesive layer 30. Moreover, as shown in Fig. 10(e), the conductive paste is filled into the circuit pattern 41 to form the through-hole electrode 12 and the rear surface wiring 13 and directly join the electrode 21 of the electronic component 20 to the through-hole electrode 12.

Finally, as shown in Fig. 10(f), the surface layer circuit 14 is formed on the mounting surface 10a side of the resin base 10, whereby the component-mounting printed board 100C is manufactured. The component-mounting printed board 100C according to the second embodiment manufactured in this way allows thinning to be achieved and is capable of high density mounting similarly to the first embodiment, and is capable also of high density mounting on the mounting surface 10a side. Moreover, the component-mounting printed board 100C may be manufactured as follows.

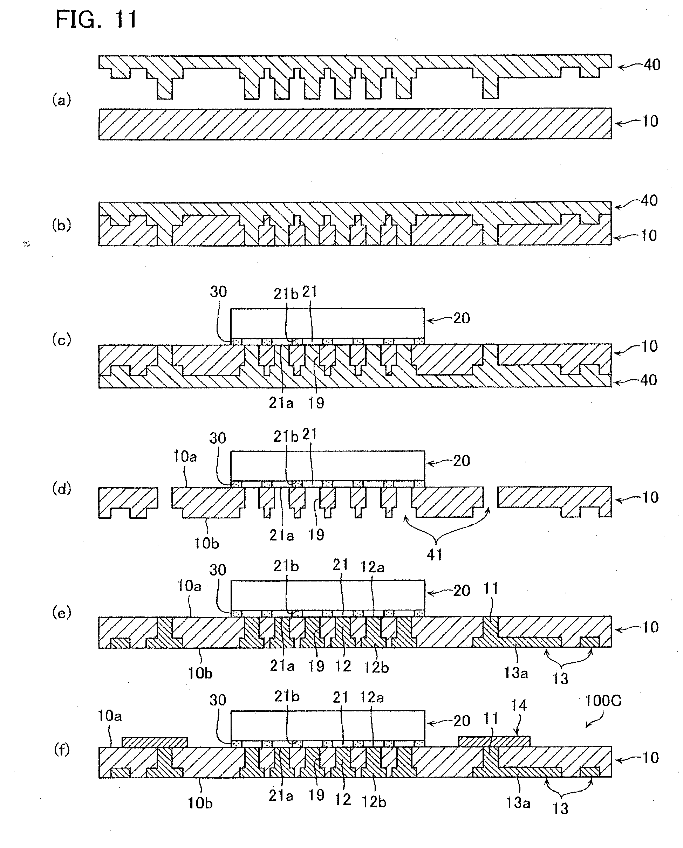

Fig. 11 is a cross-sectional view showing the component-mounting printed board in a second manufacturing process sequence. This second manufacturing process is characterized in that an order of a processing for mold separation of the imprint mold 40 and a processing for mounting of the electronic component 20 in the first manufacturing process shown in Fig. 10 is reversed. That is, the electronic component 20 having the adhesive layer 30 formed thereon, is prepared, then as shown in Fig. 11(a), first, the imprint mold 40 and the resin base 10 are prepared, and then, as shown in Fig. 11(b), the imprint mold 40 is impressed into the resin base 10 to transfer the circuit pattern.

Next, as shown in Fig. 11(c), after inverting the resin base 10 and performing alignment, the electronic component 20 is mounted on the mounting surface 10a of the resin base 10, and, while adhering a portion of the electrode surface 21a to the mounting surface 10a, the electronic component 20 is truly adhered to the resin base 10 by the adhesive layer 30. Then, as shown in Fig. 11(d), the imprint mold 40 undergoes mold separation from the resin base 10 to form the concave circuit pattern 41, and, as shown in Fig. 11(e), the conductive paste is filled into the circuit pattern 41 to form the through-hole electrode 12 and the rear surface wiring 13 and directly join the electrode 21 of the electronic component 20 to the through-hole electrode 12.

Finally, as shown in Fig. 11(f), the surface layer circuit 14 is formed on the mounting surface 10a side of the resin base 10, whereby the component-mounting printed board 100C is manufactured. As a result of the second manufacturing process being configured to mount the electronic component 20 before performing mold separation of the imprint mold 40 from the resin base 10 in this way, loss of shape of the circuit pattern 41 formed in the resin base 10 during mounting can be more reliably prevented.

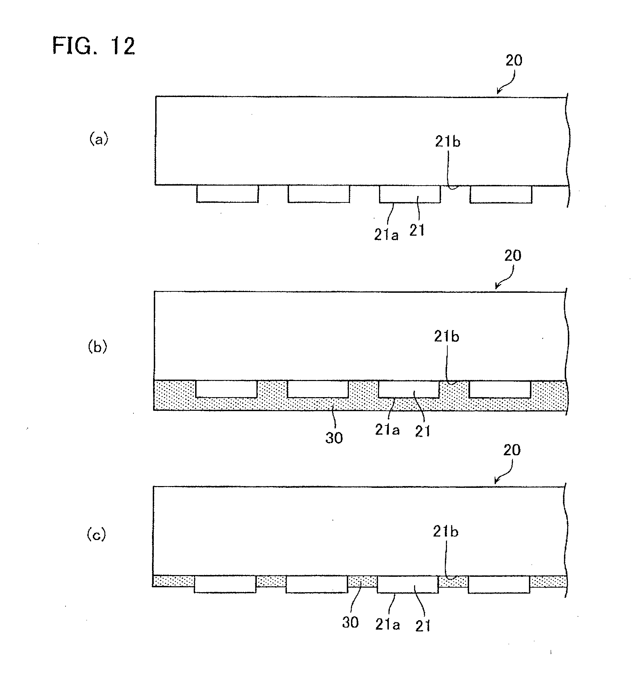

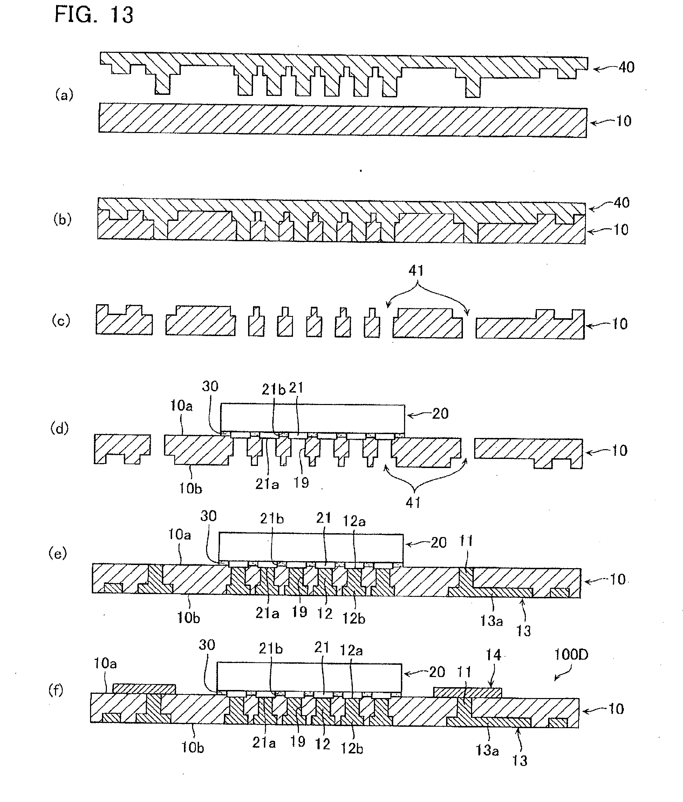

The component-mounting printed board according to the second embodiment may be manufactured as follows. Fig. 12 is a cross-sectional view showing the electronic component of the component-mounting printed board in a manufacturing process sequence, and Fig. 13 is a cross-sectional view showing the component-mounting printed board in a manufacturing process sequence. First, distinct from a main manufacturing process of a component-mounting printed board 100D shown in Fig. 13, as shown in Fig. 12(a), the electronic component 20 having a plurality of the electrodes 21 formed on the electrode formation surface 21b, is prepared, and, as shown in Fig. 12(b), an adhesive agent is coated (or laminated) on this electrode formation surface 21b of the electronic component 20 to form the adhesive layer 30.

Employable as the adhesive agent coated or laminated here is a liquid form or film form adhesive agent configured from the above-described kind of thermoplastic resin or semi-hardened-state thermosetting resin. Then, as shown in Fig. 12(c), by etching or ashing, and so on, the adhesive layer 30 is configured to not protrude from a side surface of the electronic component 20, and a surface of the adhesive layer 30 is provided in a state of being more recessed to a side of the electrode formation surface 21b than is the electrode surface 21a of the electrode 21, whereby the adhesive layer 30 is formed having the electrode 21 protruding therefrom.

Then, as shown in Fig. 13(a), the imprint mold 40 and the resin base 10 are prepared, and, as shown in Fig. 13(b), the imprint mold 40 is impressed into the resin base 10 to transfer the circuit pattern. Subsequently, as shown in Fig. 13 (c), the imprint mold 40 undergoes mold separation from the resin base 10, whereby the concave circuit pattern 41 is formed in the resin base 10.

Next, as shown in Fig. 13(d), the resin base 10 is inverted and alignment of the electronic component 20 is performed, and then heat and pressure are applied to mount the electronic component 20 on the mounting surface 10a such that the electrode 21 is embedded in the resin base 10, and, simultaneously, the electronic component 20 is truly adhered to the resin base 10 by the adhesive layer 30. In this case, as mentioned above, a contact area of the electrode 21 of the electronic component 20 contacting the resin base 10 is large, hence the electronic component 20 can be more reliably truly adhered to the resin base 10. Then, as shown in Fig. 13(e), the conductive paste is filled into the circuit pattern 41 to form the through-hole electrode 12 and the rear surface wiring 13 and directly join the electrode 21 of the electronic component 20 to the through-hole electrode 12.

Finally, as shown in Fig. 13(f), the surface layer circuit 14 is formed on the mounting surface 10a side of the resin base 10, whereby the component-mounting printed board 100D is manufactured. Even when the component-mounting printed board 100D according to the second embodiment is manufactured in this way, thinning can be achieved and high density mounting is enabled similarly to the first embodiment, and high density mounting on a side of the mounting surface 10a is also enabled.

### Description of reference numerals

- 10: resin base
- 10a: mounting surface
- 10b: rear surface
- 11: interlayer connector
- 11a: electrode
- 12: through-hole electrode
- 12a: electrode
- 12b: electrode pad
- 13: rear surface wiring
- 13a: wiring main portion
- 14: surface layer circuit
- 19: through-hole
- 20: electronic component
- 21: electrode
- 21a: electrode surface
- 21b: electrode formation surface
- 30: adhesive layer
- 31: filling device
- 40: imprint mold
- 41: circuit pattern
- 100: component-mounting printed board

## Claims

1. A component-mounting printed board (100), comprising:
a resin base (10);
an electronic component (20) mounted on at least one of surfaces (10a, 10b) of the resin base (10); and
a through-hole electrode (12) formed penetrating the resin base (10) at a position corresponding to an electrode (21) of the electronic component (20), wherein
the electrode (21) of the electronic component (20) and the through-hole electrode (12) are directly joined, and an electrode pad (12b) of the through-hole electrode (12) is embedded in the resin base (10) and formed in a surface (10b) on an opposite side to a side of a mounting surface (10a) on which the electronic component (20) is mounted of the resin base (10),
**characterized in that**
a circuit (14) is formed on the side of the mounting surface (10a) on which the electronic component (20) is mounted of the resin base (10), and
the electrode pad (12b) of the through-hole electrode (12) and a surface of a rear surface wiring (13) are formed in a state of being flat with the surface (10b) on the opposite to the mounting surface (10a) of the resin base (10).

2. The component-mounting printed board (100) according to claim 1, wherein
the electrode (21) of the electronic component (20) is embedded in the resin base (10).

3. The component-mounting printed board (100) according to claim 1 or 2, wherein
an adhesive layer(30) is formed between an electrode formation surface(21b) of the electronic component(20) and the mounting surface(10a) of the resin base(10).

4. The component-mounting printed board (100) according to claim 3, wherein
the adhesive layer (30) is formed only in an underside region of the electronic component (20).

5. A method of manufacturing a component-mounting printed board (100), comprising:
forming a circuit pattern (41) in a resin base (10) by imprinting, the circuit pattern (41) including a through-hole (19);
aligning an electrode (21) of an electronic component (20) with the through-hole (19) of the circuit pattern (41) to perform alignment, and then mounting the electronic component (20) on the resin base (10); and
filling a conductive paste into the circuit pattern (41) to form in the resin base wiring including a through-hole electrode (12) corresponding to the through-hole (19) and directly join the electrode (21) of the electronic component (20) and the through-hole electrode (12), and forming an electrode pad (12b) of the through-hole electrode (12) being embedded in the resin base (10) in a surface (10b) on an opposite side to a side of a mounting surface (10a) on which the electronic component (20) is mounted of the resin base (10).

6. The method of manufacturing a component-mounting printed board (100) according to claim 5, wherein
when mounting the electronic component (20) on the resin base (10), the electronic component (20) is mounted while the resin base (10) is heated and while a contact surface (10a) with the electrode (21) of the electronic component (20) of the resin base (10) is pressurized.

7. The method of manufacturing a component-mounting printed board (100) according to claims 5 or 6, wherein
an intermetallic compound is formed between the electrode (21) of the electronic component (20) and the conductive paste.

8. The method of manufacturing a component-mounting printed board (100) according to any one of claims 5 to 7, wherein
prior to mounting the electronic component (20) on the resin base (10), an adhesive layer (30) is formed in a region where the electrode (21) in an electrode formation surface (21 b) of the electronic component (20) is not formed.

9. The method of manufacturing a component-mounting printed board (100) according to claim 8, wherein
the adhesive layer (30) is formed such that a surface thereof is in a state of being more recessed to a side of the electrode formation surface (21b) of the electronic component (20) than is an electrode surface (21a) of the electrode (21) of the electronic component (20).

## Patentansprüche

1. Bestückungsleiterplatte (100), umfassend:
Trägermaterial aus Kunstharz (10);
ein elektronisches Bauelement (20), das auf mindestens einer der Oberflächen (10a, 10b) des Kunstharz-Trägermaterials (10) montiert ist; und
eine Durchkontaktelektrode (12), die ausgebildet ist, das Kunstharz-Trägermaterial (10) an einer Position, die einer Elektrode (21) des elektronischen Bauelements (20) entspricht, zu durchdringen, wobei
die Elektrode (21) des elektronischen Bauelements (20) und die Durchkontaktelektrode (12) direkt verbunden sind, und eine Elektrodenkontaktstelle (12b) der Durchkontaktelektrode (12) in dem Kunstharz-Trägermaterial (10) eingebettet und ausgebildet ist in einer Fläche (10b) auf einer gegenüber liegenden Seite zu einer Seite einer Montagefläche (10a) des Kunstharz-Trägermaterials (10), auf der das elektronische Bauelement (20) montiert ist,
**dadurch gekennzeichnet, dass**
ein Schaltkreis (14) gebildet ist auf der Seite der Montagefläche (10a) des Kunstharz-Trägermaterials (10), auf der das elektronische Bauelement (20) montiert ist, und
die Elektrodenkontaktstelle (12b) der Durchkontaktelektrode (12) und eine Fläche einer Verdrahtung (13) auf der Rückfläche in einem zur Fläche (10b) flachen Zustand im Gegensatz zur Montagefläche (10a) des Kunstharz-Trägermaterials (10) ausgebildet sind.

2. Bestückungsleiterplatte (100) nach Anspruch 1, wobei
die Elektrode (21) des elektronischen Bauelements (20) in dem Kunstharz-Trägermaterial (10) eingebettet ist.

3. Bestückungsleiterplatte (100) nach Anspruch 1 oder 2, wobei eine Klebstoffschicht (30) zwischen einer Elektrodenausbildungsfläche (21 b) des elektronischen Bauelements (20) und der Montagefläche (10a) des Kunstharz-Trägermaterials (10) gebildet ist.

4. Bestückungsleiterplatte (100) nach Anspruch 3, wobei
die Klebstoffschicht (30) nur in einem Unterseitenbereich des elektronischen Bauelements (20) gebildet ist.

5. Verfahren zur Herstellung einer Bestückungsleiterplatte (100), umfassend:
Bilden einer Schaltkreisstruktur (41) in einem Kunstharz-Trägermaterial (10) durch Aufbelichten, wobei die Schaltkreisstruktur (41) ein Durchkontaktloch (19) einschließt;
Justieren einer Elektrode (21) eines elektronischen Bauelements (20) mit dem Durchkontaktloch (19) der Schaltkreisstruktur (41), um Überdeckung zu bewirken, und anschließendes Montieren des elektronischen Bauelements (20) auf dem Kunstharz-Trägermaterial (10); und
Füllen einer leitfähigen Paste in die Schaltkreisstruktur (41) zum Bilden einer Verdrahtung einschließlich einer Durchkontaktelektrode (12) in dem Kunstharz-Trägermaterial, die dem Durchkontaktloch (19) entspricht und direktes Fügen der Elektrode (21) des elektronischen Bauelements (20) und der Durchkontaktelektrode (12) und Bilden einer Elektrodenkontaktstelle (12b) der Durchkontaktelektrode (12), die in dem Kunstharz-Trägermaterial (10) in einer Fläche (10b) des Kunstharz-Trägermaterials (10) auf einer gegenüberliegenden Seite zu einer Seite einer Montagefläche (10a), auf der das elektronische Bauelement (20) montiert wird, eingebettet ist.

6. Verfahren zur Herstellung einer Bestückungsleiterplatte (100) nach Anspruch 5, wobei
bei Montage des elektronischen Bauelements (20) auf dem Kunstharz-Trägermaterial (10) das elektronische Bauelement (20) montiert wird, während das Kunstharz-Trägermaterial (10) erhitzt wird und während eine Kontaktfläche (10a) mit der Elektrode (21) des elektronischen Bauelements (20) des Kunstharz-Trägermaterials (10) zusammengedrückt wird.

7. Verfahren zur Herstellung einer Bestückungsleiterplatte (100) nach Anspruch 5 oder Anspruch 6, wobei
eine intermetallische Verbindung gebildet wird zwischen der Elektrode (21) des elektronischen Bauelements (20) und der leitfähigen Paste.

8. Verfahren zur Herstellung einer Bestückungsleiterplatte (100) nach einem der Ansprüche 5 bis 7, wobei
vor Montage des elektronischen Bauelements (20) auf dem Kunstharz-Trägermaterial (10) eine Klebstoffschicht (30) in einem Bereich gebildet wird, wo die Elektrode (21) in einer Elektrodenausbildungsfläche (21b) des elektronischen Bauelements (20) nicht ausgebildet ist.

9. Verfahren zur Herstellung einer Bestückungsleiterplatte (100) nach Anspruch 8, wobei
die Klebstoffschicht (30) so ausgebildet ist, dass sich eine Fläche davon in einem Zustand befindet, wo sie zu einer Seite der Elektrodenausbildungsfläche (21b) des elektronischen Bauelements (20) mehr ausgespart ist als es eine Elektrodenfläche (21 a) der Elektrode (21) des elektronischen Bauelements (20) ist.

## Revendications

1. Carte à circuit imprimé pour montage de composants (100), comprenant :
une base de résine (10) ;
un composant électronique (20) monté sur au moins l'une des surfaces (10a, 10b) de la base de résine (10) ; et
une électrode pour trou-traversant (12) formée par pénétration de la base de résine (10) à une position correspondant à une électrode (21) du composant électronique (20), où
l'électrode (21) du composant électronique (20) et l'électrode pour trou-traversant (12) sont directement jointes, et un plot d'électrode (12b) de l'électrode pour trou-traversant (12) est enchâssé dans la base de résine (10) et formé dans une surface (10b) sur un côté opposé à un côté d'une surface de montage (10a) sur laquelle est monté le composant électronique (20) de la base de résine (10),
**caractérisée en ce que**
un circuit (14) est formé sur le côté de la surface de montage (10a) sur laquelle est monté le composant électronique (20) de la base de résine (10), et
le plot d'électrode (12b) de l'électrode pour trou-traversant (12) et une surface d'un câblage de surface arrière (13) sont formés sous un état plan avec la surface (10b) à l'opposé de la surface de montage (10a) de la base de résine (10).

2. Carte à circuit imprimé pour montage de composants (100) selon la revendication 1, où
l'électrode (21) du composant électronique (20) est enchâssée dans la base de résine (10).

3. Carte à circuit imprimé pour montage de composants (100) selon la revendication 1 ou 2, où
une couche adhésive (30) est formée entre une surface de formation d'électrode (21b) du composant électronique (20) et de la surface de montage (10a) de la base de résine (10).

4. Carte à circuit imprimé pour montage de composants (100) selon la revendication 3, où
la couche adhésive (30) est formée uniquement dans une région du côté inférieur du composant électronique (20).

5. Procédé de fabrication d'une carte à circuit imprimé pour montage de composants (100), comprenant :
la formation d'un motif de circuit (41) dans une base de résine (10) par empreinte, le motif de circuit (41) incluant un trou-traversant (19) ;
l'alignement d'une électrode (21) d'un composant électronique (20) avec le trou-traversant (19) du motif de circuit (41) pour exécuter l'alignement, et ensuite le montage du composant électronique (20) sur la base de résine (10) ; et
le garnissage d'une pâte conductrice dans le motif de circuit (41) à former dans le câblage de base de résine incluant une électrode pour trou-traversant (12) correspondant au trou-traversant (19) et la jonction directement de l'électrode (21) du composant électronique (20) et de l'électrode pour trou-traversant (12), et la formation d'un plot d'électrode (12b) de l'électrode pour trou-traversant (12) qui est enchâssée dans la base de résine (10) dans une surface (10b) sur un côté opposé à un côté d'une surface de montage (10a) sur laquelle est monté le composant électronique (20) de la base de résine (10).

6. Procédé de fabrication d'une carte à circuit imprimé pour montage de composants (100) selon la revendication 5, où
lors du montage du composant électronique (20) sur la base de résine (10), le composant électronique (20) est monté pendant que la base de résine (10) est chauffée et pendant qu'une surface de contact (10a) avec l'électrode (21) du composant électronique (20) de la base de résine (10) est mise sous pression.

7. Procédé de fabrication d'une carte à circuit imprimé pour montage de composants (100) selon les revendications 5 ou 6, où
un composé intermétallique est formé entre l'électrode (21) du composant électronique (20) et de la pâte conductrice.

8. Procédé de fabrication d'une carte à circuit imprimé pour montage de composants (100) selon l'une quelconque des revendications 5 à 7, où
avant le montage du composant électronique (20) sur la base de résine (10), une couche adhésive (30) est formée dans une région où l'électrode (21) dans une surface de formation d'électrode (21b) du composant électronique (20) n'est pas formée.

9. Procédé de fabrication d'une carte à circuit imprimé pour montage de composants (100) selon la revendication 8, où
la couche adhésive (30) est formée de sorte qu'une surface de celle-ci se trouve en l'état d'être plus enfoncée au niveau d'un côté de la surface de formation d'électrode (21b) du composant électronique (20) par rapport à une surface d'électrode (21a) de l'électrode (21) du composant électronique (20).
